**Europäisches Patentamt**

**European Patent Office**

**Office européen des brevets**

(11) Veröffentlichungsnummer: **0 019 890**
**B1**

(12) # EUROPÄISCHE PATENTSCHRIFT

(45) Veröffentlichungstag der Patentschrift:
**13.04.83**

(51) Int. Cl.³: **H 01 F 7/18**

(21) Anmeldenummer: **80102906.7**

(22) Anmeldetag: **23.05.80**

(54) **Schaltungsanordnung zur Ansteuerung von Magneten in Aufzeichnungsgeräten der Fernschreibtechnik.**

(30) Priorität: **01.06.79 DE 2922521**

(43) Veröffentlichungstag der Anmeldung:
**10.12.80 Patentblatt 80/25**

(45) Bekanntmachung des Hinweises auf die Patenterteilung:
**13.04.83 Patentblatt 83/15**

(84) Benannte Vertragsstaaten:
**FR GB IT NL SE**

(56) Entgegenhaltungen:
**DE-A-2 247 546**
**DE-A-2 532 715**
**US-A-3 549 955**

**Die Akte enthält technische Angaben, die nach dem Eingang der Anmeldung eingereicht wurden und die nicht in dieser Patentschrift enthalten sind.**

(73) Patentinhaber: **SIEMENS AKTIENGESELLSCHAFT,
Berlin und München Wittelsbacherplatz 2,
D-8000 München 2 (DE)**

(72) Erfinder: **Lichti, Reiner, Ing.-grad.,
Kerschensteinerstrasse 228, D-8034 Germering (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Schaltungsanordnung zur Ansteuerung von Magneten in Aufzeichnungsgeräten
der Fernschreibtechnik

Bei der Aufzeichung von Informationen in lesbarer Form, oder bei der Erstellung von Informationsträgern in Form von Lochstreifen, finden als Antriebselemente Elektromagnete Anwendung. Als Beispiel sei hier auf die sogenannten Nadeldruckwerke hingewiesen, wo jede Nadel vom Anker eines Elektromagneten aus der Ruhelage in die Druckstellung gebracht wird. Bei einem solchen Druckwerk ist jeder einzelnen Druckernadel ein Magnetsystem zugeordnet, das entsprechend gesteuert die Druckernadeln gegen die Schreibfläche bewegt. Für den ordnungsgemäßen Betrieb wird dabei eine geringe Anzugszeit, eine schnelle Abfallzeit und ein geringer Leistungsbedarf gefordert. Eine Ansteuerschaltung dafür ist aus der DE-B1-2 515 124 bekannt. In dieser bekannten Anordnung liegt die Spule jedes Magneten in Reihe mit zwei hintereinandergeschalteten Schalttransistoren, die über zwei in ihrer zeitlichen Dauer einstellbare Steuerimpulse ansteuerbar sind. Weiterhin sind dort zwei Spannungsquellen vorgesehen, die auf Grund der zeitlich getrennt ansteuerbaren Schalttransistoren die Magnetspule zunächst mit einer hohen Spannung beaufschlagen, durch die ein schneller Aufbau des Magnetfeldes erfolgt, um danach lediglich mit der zweiten niedrigeren Spannung den erforderlichen Haltestrom fließen zu lassen. Damit läßt sich ein am Ausgang der Ansteuerschaltung abgegebener Stromverlauf mit einem für eine Stromkonstantschaltung typischen Verlauf erreichen. Derartige Schaltungen bedingen jedoch wegen der verschiedenen Spannungen einen unerwünschten Aufwand. Darüber hinaus führt der Abbau der Abschaltenergie in einer solchen Schaltung zu Verlustwärme und damit zu einer thermischen Belastung.

Aus der DE-A1-2 532 715, die dem Oberbegriff des Anspruchs 1 zugrunde liegt, ist bereits eine Schnellsteuerschaltung für Elektromagnete bekannt, die nur mit einer einzigen Spannung arbeitet, mit der geringe Anzugs- und Abschaltezeiten erreichbar sind, und die nur eine geringe Leistung erfordert.

Der Erfindung liegt die Aufgabe zugrunde, die gleichen günstigen Anzugs- und Abschaltzeiten auch in Verbindung mit der Ansteuerung von Magneten für Druck- und Lochereinrichtungen zu erzielen, wobei der Schaltungsaufwand jedoch möglichst gering sein soll. Diese Aufgabe wird erfindungsgemäß durch die im kennzeichnenden Teil des Patentanspruches 1 angegebenen Merkmale gelöst.

Die erfindungsgemäße Ansteuerschaltung benötigt nur eine einzige Betriebsspannung, da die für den Haltestrom benötigte Energie durch Einbeziehung der Induktivität der Magnetspule in den Haltestromkreis mit herangezogen wird.

Die erfindungsgemäße Anwendung von Rückspeisediode und zweitem Schalttransistor gemeinsam für mehrere Magnete, führt darüber hinaus zu einer merklichen Verminderung des Schaltungsaufwandes. Da die durch die DE-A1-2 532 715 bekannte Ansteuerschaltung eine Strommessung durch den zweiten Schalttransistor zur Magnetstromregelung verwendet, wären dort im Falle der Ansteuerung mehrerer Magnete im Gegensatz zur Erfindung Rückspeisediode und zweiter Schalttransistor für jeden Magneten einzeln vorzusehen.

Das Ansteuerungsprinzip wird im folgenden anhand der Zeichnungen erläutert. Dabei zeigt

Fig. 1 eine erfindungsgemäße Ansteuerschaltung, wobei die Schaltungsteile V2, D3 als nur einmal vorhanden anzusehen sind, während die übrigen Schaltungsteile entsprechend der Zahl der Magneten mehrfach vorhanden sind, was in der Figur jedoch nicht besonders dargestellt ist.

Fig. 2 und 3 Impulsdiagramme zur Erläuterung der Anordnung nach Fig. 1.

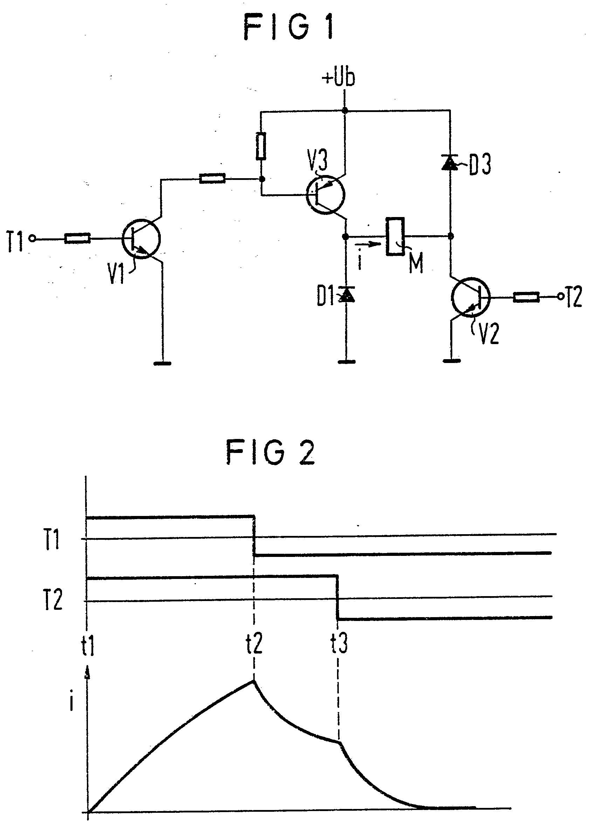

Die Schaltung gemäß Fig. 1 besteht aus einem ersten und einem zweiten Schalttransistor V1 und V2, die durch die beiden Steuerimpulse T1 und T2 steuerbar sind. Der Magnet M liegt in einem, einen Steuertransistor V3 und den zweiten Schalttransistor V2 enthaltenden Stromkreis, der mit einer einzigen Betriebsspannung +Ub verbunden ist. Für den Magneten M besteht darüber hinaus ein Haltestromkreis, der eine Diode D1, den Magneten M und den Schalttransistor V2 umfaßt. Zur Rückspeisung der in dem Magneten M gespeicherten Energie ist eine Rückspeisediode D3 vorgesehen. Die Wirkungsweise dieser Schaltung wird anhand des in F i g. 2 dargestellten Impulsdiagramms im einzelnen erläutert. Durch die an den beiden Steuereingängen zum Zeitpunkt t1 anliegenden Steuerimpulse T1 und T2 sind die beiden Schalttransistoren V1 und V2 leitend. Über den ersten Schalttransistor V1 ist damit auch der Steuertransistor V3 leitend, über den der Magnet M an die Betriebsspannung +Ub angeschaltet ist. Während der Zeit des ersten Steuerimpulses T1 steigt der Strom i in der Spule des Magneten M an. Die Dauer von T1 bestimmt den Spitzenwert von i und damit die Anzugszeit des Magneten M. Mit der Abschaltung des ersten Steuerimpulses T1 zum Zeitpunkt t2 wird der erste Schalttransistor V1 und damit auch der Steuertransistor V3 gesperrt, und der Magnet M wird von der Betriebsspannung +Ub abgeschaltet. Da der Magnet M jedoch in einem die Diode D1 und den zweiten Schalttransistor V2 enthaltenden Haltestromkreis liegt, und der zweite Steuerimpuls T2 zu diesem Zeitpunkt den zweiten Schalttransistor V2 noch leitend hält, wird der Stromfluß im Haltestromkreis über die Diode D1 und den zweiten Schalttransistor V2 aufrechterhalten. Als Energiequelle steht dabei die Induktivität der Spule, d. h. die in der Spule des Magneten M gespeicherte Energie zur Verfügung, die unter den üblichen Bedingungen ausreicht, den Haltestrom für den Magneten M zu liefern. Zum Zeitpunkt t3 wird über den zweiten Steuerimpuls T2 nunmehr auch der zweite Schalttransistor V2 gesperrt und damit der Haltestromkreis für den Magneten M unterbrochen.

Die in der Spule des Magneten M gespeicherte Energie wird nun über die jetzt leitenden Dioden D1 und D3 in das Versorgungsnetz zurückgespeist. Der Verlauf des Stromes i in dem Magneten M während der Anzugszeit und der Haltezeit, sowie den Stromverlauf in der Abschaltphase, zeigt ebenfalls Fig. 2.

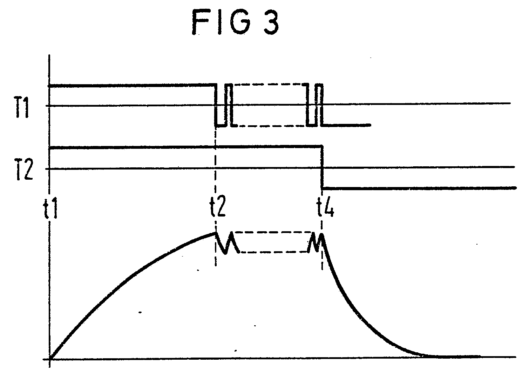

Um zu verhindern, daß in bestimmten Fällen der Strom während der Haltephase unter einen vorgegebenen Wert absinkt, kann gemäß einer Ausgestaltung der Erfindung der Steuertransistor V3 über den ersten Schalttransistor V1 und den ersten Steuerimpuls T1 während der Haltephase periodisch ein- und ausgeschaltet werden. Der Schaltungsaufbau entspricht dabei der anhand von Fig. 1 bereits beschriebenen Schaltungsanordnung. Lediglich die Ansteuerung durch den ersten Steuerimpuls T1 ist hierbei durch die Wahl des Impulsverlaufs während der Haltephase zu ändern. Wie Fig. 3 zeigt, werden in diesem Falle mit dem ersten und dem zweiten Steuerimpuls T1 und T2 zunächst die beiden Schalttransistoren V1 und V2 ebenfalls leitend gesteuert, und der Strom i in dem Magneten M steigt während der Anschaltedauer T1 an. Zum Zeitpunkt t2 wird der erste Steuerimpuls T1 periodisch ein- und ausgeschaltet. Dabei ergibt sich der in Fig. 3 für einen Stromverlauf i dargestellte sägezahnförmige Verlauf. Die Beendigung des ersten Steuerimpulses T1 und damit die endgültige Sperrung der Schalttransistoren V1 und V2 findet nach Ablauf der Haltephase zum Zeitpunkt t4 statt und führt wie anhand von Fig. 1 und Fig. 2 beschrieben wurde, zum raschen Stromabfall. Der in Fig. 3 dargestellte Stromverlauf ist dabei durch eine entsprechende Wahl des Impuls-Pausen-Verhältnisses des ersten Steuerimpulses einstellbar.

Die beschriebene Schaltungsanordnung ist deshalb besonders zur Ansteuerung von Magnetsystemen in Lochereinrichtungen geeignet, weil in diesem Fall die in den Spulen der Magnetsysteme gespeicherte Energie relativ groß ist und der Schaltungsteil V2, D3 zur Ansteuerung mehrerer Magnete verwendet werden kann.

**Patentansprüche**

1. Schaltungsanordnung zur Ansteuerung von aus einer Gleichspannungsquelle speisbaren Magneten (M), bei der die Spule jedes Antriebsmagneten in Reihe zwischen einem durch einen ersten Schalttransistor (V1) steuerbaren Steuertransistor (V3) einerseits und einem zweiten Schalttransistor (V2) andererseits an die Gleichspannungsquelle anschließbar ist, und die Spulenenden mit dem jeweils entgegengesetzten Pol der Gleichspannungsquelle über jeweils eine in Sperrichtung gepolte Diode (D1, D3) verbunden sind, wobei die Steuerung derart ausgebildet ist, daß während einer die Anzugszeit des Magneten umfassenden Zeitdauer die Spule über den Steuertransistor (V3) und den zweiten Schalttransistor (V2) an die Gleichspannungsquelle angeschaltet ist, daß anschließend bei gesperrtem Steuertransistor (V3) ein Haltestromkreis über den zweiten Schalttransistor (V2) und die am gleichen Pol der Gleichspannungsquelle liegende Diode (D1) gebildet ist, in dem die Induktivität der Spule als Stromquelle wirkt, und daß dieser Haltestromkreis über den zweiten Schalttransistor (V2) unterbrechbar ist, wobei die am entgegengesetzten Pol liegende Diode als Rückspeisediode (D3) zur Rückspeisung der im Magneten (M) gespeicherten Energie auf die Gleichspannungsquelle dient, dadurch gekennzeichnet, daß in Anwendung auf Antriebsmagneten (M) in druckenden oder lochenden Aufzeichnungsgeräten der Fernschreibtechnik die Rückspeisediode (D3) und der zweite Schalttransistor (V2) für mehrere Antriebsmagnete (M) nur einmal vorgesehen sind.

2. Schaltungsanordnung nach Anspruch 1, dadurch gekennzeichnet, daß der erste Schalttransistor (V1) während der Dauer der Anzugszeit ständig eingeschaltet und während der Dauer einer Haltezeit periodisch ein- und ausgeschaltet ist.

**Claims**

1. A circuit arrangement for the operation of magnets (M) which can be fed from a direct voltage source, wherein the coil of each driving magnet can be connected in series to the direct voltage source between a first switching transistor (VI), controllable by a control transistor (V3), and a second switching transistor (V2), and wherein the coil ends are each connected to the opposite pole of the direct voltage source by means of a respective diode (D1, D3) each poled in the blocking direction, the control being designed in such manner that during a length of time comprising the energisation time of the magnet the coil is connected to the direct voltage source via the control transistor (V3) and the second switching transistor (V2), that subsequently, when the control transistor (V3) is blocked, a holding circuit is formed via the second switching transistor (V2) and the diode (D1) lying at the same pole of the direct voltage source, the inductance oft the coil acting as a current source, and that this holding circuit can be interrupted by means of the second switching transistor (V2), where the diode (D3) lying at the opposite pole serves as a feedback diode in order to return the energy stored in the magnet (M) to the direct voltage source, characterised in that when applied to driving magnets (M) in printing or in punching recording devices relating to teleprinting technology, a common feedback diode (D3) and common second switching transistor (V2) are provided for a plurality of driving magnets (M).

2. A circuit arrangement as claimed in Claim 1, characterised in that the first switching transistor (V1) is constantly switched on for the duration of the energisation time and periodically switched on and off during the holding time.

**Revendications**

1. Circuit pour réaliser l'excitation d'aimants (M) pouvant être alimentés à partir d'une source de tension continue, dans lequel la bobine de chaque aimant moteur peut être raccordée en série entre un transistor de commande (V3), pouvant être commandé par un premier transistor de commutation (V1), d'une part, et un second transistor de commutation (V2) d'autre part à la source de tension continue, et dans lequel les extrémités des bobines sont reliées au pôle respectivement opposé de la source de tension continue par l'intermédiaire d'une diode respective (D1, D3) polarisée en inverse, et dans lequel la commande est réalisée de telle manière que pendant une durée incluant la durée d'attraction de l'aimant, la bobine est raccordée, par l'intermédiaire du transistor de commande (V3) et du second transistor de commutation (V2), à la source de tension continue, qu'ensuite, lorsque le transistor de commande (V3) est à l'état bloqué, un circuit de maintien se trouve formé au moyen du second transistor de commutation (V2) et de la diode (D1) raccordée au même pôle de la source de tension continue et dans lequel l'inductance de la bobine sert de source de courant, et que ce circuit de maintien peut être interrompu au moyen du second transistor de commutation (V2), auquel cas la diode raccordée au pôle opposé sert de diode d'alimentation en retour (D3) pour renvoyer l'énergie stockée dans l'aimant (M) à la source de tension continue, caractérisé en ce que dans le cas d'une utilisation avec des aimants moteurs (M) dans des appareils d'enregistrement, effectuant une impression ou une perforation, de la technique du téléscripteur, la diode d'alimentation en retour (D3) et le second transistor de commutation (V2) ne sont prévus qu'en un exemplaire pour plusieurs aimants moteurs (M).

2. Circuit selon la revendication 1, caractérisé en ce que le premier transistor de commutation (V1) est branché en permanence pendant la durée de la période d'attraction et est branché et débranché périodiquement pendant la durée d'une période de maintien.

# F I G 1

# F I G 2

# FIG 3